# EUROPÄISCHE PATENTSCHRIFT

(11) **EP 2 697 817 B1**
(45) Veröffentlichungstag und Bekanntmachung des Hinweises auf die Patenterteilung: **11.03.2015**
(21) Anmeldenummer: 12718058.6
(22) Anmeldetag: 26.03.2012
(51) Int. Cl.: H01J 37/32

(54) **KOHLENSTOFFFUNKENVERDAMPFUNG**
CARBON SPARK EVAPORATION
VAPORISATION D'ÉTINCELLES DE CARBONE

(30) Priorität: 11.04.2011 DE 102011016681
(43) Veröffentlichungstag der Anmeldung: 19.02.2014
(73) Patentinhaber: Oerlikon Trading AG, Trübbach, 9477 Trübbach (CH)
(72) Erfinder: RAMM, Jürgen, 7304 Maienfeld (CH); WIDRIG, Beno, 7310 Bad Ragaz (CH); RUHM, Kurt, 9495 Triesen (LI)
(74) Vertreter: Kempkens, Anke
(86) Internationale Anmeldenummer: PCT/EP2012/001322
(87) Internationale Veröffentlichungsnummer: WO 2012/139707

(56) Entgegenhaltungen:
- WO-A1-2009/059807
- WO-A2-2006/099758
- DE-A1- 4 401 986
- US-A- 4 645 895
- ANDERS A ET AL: "'TRIGGERLESS' TRIGGERING OF VACUUM ARCS", JOURNAL OF PHYSICS D. APPLIED PHYSICS, IOP PUBLISHING, BRISTOL, GB, Bd. 31, Nr. 5, 7. März 1998 (1998-03-07), Seiten 584-587, XP000771398, ISSN: 0022-3727, DOI: 10.1088/0022-3727/31/5/015 in der Anmeldung erwähnt

## Beschreibung

Die Erfindung bezieht sich auf ein Verfahren zur kathodischen Funkenverdampfung von Kohlenstofftargets oder stark kohlenstoffhaltigen Targets zur Herstellung von Kohlenstoffschichten oder Schichten die grosse Anteile von Kohlenstoff enthalten.

Im Speziellen befasst sich die Erfindung mit der Herstellung von harten Kohlenstoffschichten, die keinen oder nur geringen Wasserstoffanteil aufweisen und deren Härte in weiten Bereichen variiert werden kann.

Erfindungsgemäss wird eine Vorrichtung angegeben, die es erlaubt, den Funken bei tiefen Spannungen auf elektrischem Wege, d.h. ohne mechanischen Zündkontakt, und mit der Möglichkeit entsprechend hoher Repetitionsfrequenzen zu zünden.

Diese Vorrichtung erlaubt es weiterhin, den Funken auf einem Kohlenstofftarget auch kleinerer Fläche und mit kleiner oder ohne Magnetfeldunterstützung sicher zu führen, um eine reproduzierbare Beschichtung im Vakuum zu garantieren.

In einem weiteren Teil werden erfindungsgemäss eine Vorrichtung und ein Verfahren beschrieben, die es erlauben, den Anteil der mehrfach geladenen Kohlenstoffionen beim Beschichten zu steuern und die Beschichtungsrate zu verändern.

Die vorteilhafte Kombination zwischen Verfahren und Vorrichtung wird dazu benutzt, um den Einbau von Spritzern, die bei der Funkenverdampfung entstehen, in die abgeschiedene Schicht stark zu verringern bzw. zu vermeiden.

Schliesslich bezieht sich die Erfindung auf eine wasserstofffreie Kohlenstoffschicht, die mit diesem Verfahren unter Benutzung der offenbarten Vorrichtung hergestellt wird, deren Härte und Oberflächenrauhigkeit über weite Bereiche variiert werden kann und mit der das tribologische System aus beschichtetem Körper und jeweiligen Gegenkörper gezielt optimiert werden kann.

Eine wichtige Ausführung der Schicht besteht in der Dotierung mit anderen Elementen, besonders mit Metallen und Gasen, ohne dass jedoch grössere Mengen von Wasserstoff eingebaut werden.

Die kathodische Funkenverdampfung von Kohlenstoff ist ein seit vielen Jahren bekanntes Verfahren, das für die Beschichtung von Werkzeugen und Bauteilen Anwendung findet. Bei diesem Verfahren bestehen die Targets aus dem zu verdampfenden Kohlenstoff und werden in einer Funkenentladung als Kathode betrieben.

Es ist Stand der Technik, die kathodische Funkenverdampfung von Kohlenstoff mit gepulstem Funkenstrom durchzuführen. Ein Gleichstrombetrieb führt zu einem "Festfressen" des Funkens an einer Stelle des Targets. Das liegt vermutlich daran, dass Graphit im Unterschied zu den üblichen metallischen Leitern für höhere Temperaturen einen kleineren spezifischen Widerstand aufweist und damit der Funkenbetrieb bei kleinerer Spannung an einer schon heissen Stelle des Targets gefördert wird. Das Pulsen des Funkenstromes lenkt den Funken ab und verhindert sein Verweilen auf einem Fleck und damit das Einbrennen in das Target.

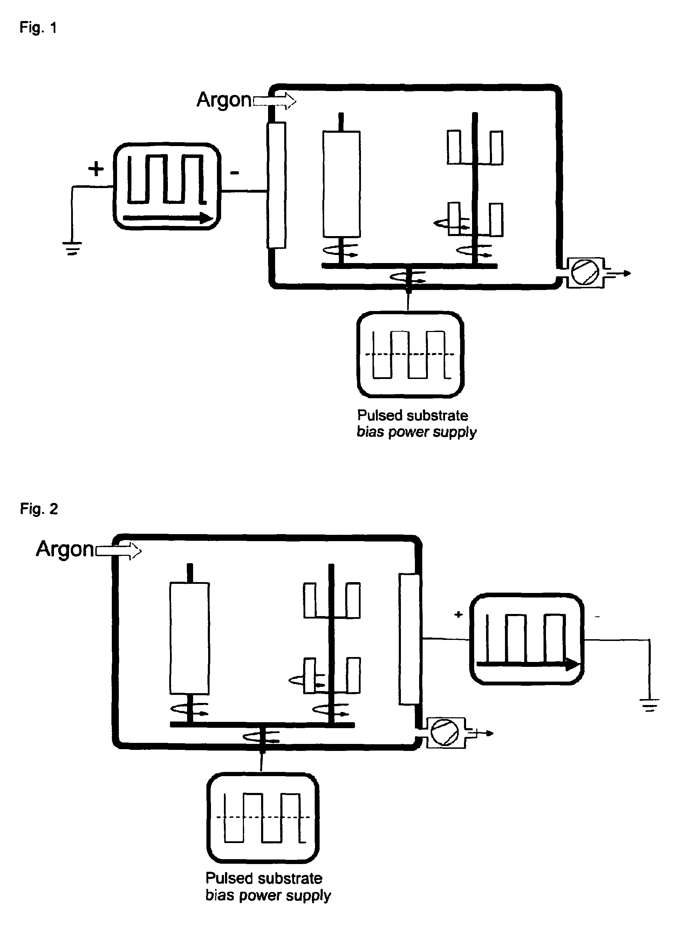

Es gibt prinzipiell zwei Arten, einen gepulsten Funkenstrom zu erzeugen. Die erste Art (im Folgenden Verfahren A genannt) besteht darin, einem kontinuierlichen Funkenstrom IKD zusätzliche Strompulse IKP zu überlagern. Dies ist in Figur 1 schematisch dargestellt. Die andere Art (im Folgenden Verfahren B genannt, Figur 2) besteht darin, lediglich Strompulse IKP für den Funkenstrom aneinander zu reihen, wobei zwischen den Strompulsen der Strom immer wieder ausgeschaltet wird und demzufolge für jeden Puls der Funken auch wieder neu gezündet werden muss, d.h. dass mit einem diskontinuierlichen Funkenstrom gearbeitet wird.

Beide Verfahren weisen Vor- und Nachteile auf. Das Verfahren A, das in der Schrift von Grimm EP_00666335_A1 beschrieben wird, hat den Vorteil, dass es lediglich einen Zündvorgang zum Zünden des kontinuierlichen Funkenstromes IKD benötigt. Die Strompulse IKP werden diesem kontinuierlichen Funkenstrom überlagert und benötigen deshalb keine eigene Zündung, was besonders vorteilhaft ist, falls die Strompulse hohe Frequenzen aufweisen. Da also nur anfänglich des Beschichtungsprozesses der kontinuierliche Funkenstrom gezündet werden muss, kann mit einer robusten und in der Produktion üblichen Zündung über kurzeitigen niederohmigen mechanischen Kontakt zwischen Kathode und Anode gearbeitet werden. Die Überlagerung des kontinuierlichen Stroms IKD, der aus der Gleichstromversorgung gespiesen wird, mit dem Pulsstrom IKP kann über eine parallel geschaltete Kondensatorentladung erfolgen oder über eine parallel geschaltete unipolare Spannungsversorgung. Es können aber auch die kommerziell erhältlichen Pulsstromversorgungen (z.B. jene die für das Pulsschweissen entwickelt wurden) eingesetzt werden, die in einem gewissen Bereich ein Einstellen der Pulsparameter (Frequenz, Pulshöhe, Pulsbreite, Pulssteilheit) erlauben.

Entsprechend wird in der Schrift von Ramm et al WO2009/059807 das Pulsverfahren unter anderem zur Herstellung von ta-C Schichten beschrieben. Dabei wird eine DC Spannung welche zu einem Grundstrom führt, mit Spannungspulsen überlagert, die das Elektronenemissionsverhalten derart beeinflusst, dass das "Festfressen" des Funkenfusspunktes, d.h. das längere Verweilen des Funkenfusspunktes auf einem sehr kleinen Bereich der Targetoberfläche, verhindert wird. Die DC-Stromversorgung erfolgt dabei mit einem Grundstrom so, dass die Plasmaentladung unterbrechungsfrei aufrechterhalten wird.

Die Notwendigkeit des kontinuierlichen Stromflusses beim Verfahren A hat allerdings zwei Nachteile, falls dieses Verfahren zur Herstellung von harten Kohlenstoffschichten benutzt wird. Der erste besteht in der Gefahr, die Schicht mit zu hohen Raten aufzubringen, nämlich über die Verdampfung durch den kontinuierlichen Funkenstrom. Es ist bekannt, das zu hohe Beschichtungsraten die diamantartigen sp3-Bindungen des Kohlenstoffs reduzieren, was in einer Arbeit von Yin et al., "A theory for the formation of tetrahedral amorphous carbon including deposition rate effects", in Thin Solid Films (1996) 95-100 beschrieben wird.

Das führt dann dazu, dass die abgeschiedenen Schichten weicher werden, was nicht wünschenswert ist, falls diese als Verschleissschutzschichten verwendet werden sollen. Ein möglicher Ausweg besteht darin, die Beschichtung in mehr oder weniger grossen Zeitintervallen zu unterbrechen. Das bedeutet dann aber, dass jeweils wieder neu gezündet werden muss und man dadurch teilweise die Vorteile des nur einmaligen Zündens bei der Kombination des Pulsstromes mit dem kontinuierlichen Funkenstrom verliert. Der andere Nachteil dieses Verfahrens besteht darin, dass der Anteil der höher geladenen Kohlenstoffionen beim kontinuierlichen Funken geringer ist.

Die andere Methode, das Verfahren B, arbeitet mit Strompulsen, zwischen denen der Funkenstrom jeweils wieder auf Null zurückgeht. Darum ist es notwendig, dass jeder Strompuls auch wieder neu gezündet werden muss. Es gibt eine Vielzahl von Methoden, diesen Zündvorgang zu realisieren. Diese werden beispielsweise in einer Publikation von Anders et al., "'Triggerless' triggering of vacuum arcs", J.Phys D: Appl. Phys, 31, (1998), 584-587 beschrieben. Alle diese Methoden haben gemeinsam, dass sie zu Beginn ein Plasma auf der Kathode oder Anode generieren, das dann die Strecke zwischen diesen beiden Elektroden genügend leitend macht für die Funkenentladung, die dann im stationären Zustand bei geringer Entladespannung abläuft. Die Zuverlässigkeit der Zündmechanismen ist unterschiedlich. Das trifft auch auf die maximale Pulszahl zu, die mit der spezifischen Zündvorrichtung erreichbar ist, ehe diese wieder überholt werden muss. Dies bedeutet, dass jeweils umfangreiche Wartungsarbeiten durchgeführt werden müssen. In den besten Fällen werden etwa 100 000 Pulse ohne eine solche Revision erreicht. Das würde bedeuten, dass nach 30 h Betriebszeit (bei eine Pulsfrequenz von 1 Hz) eine solche Revision anstünde. Würde man aber mit höheren Frequenzen arbeiten, beispielsweise mit 1 kHz Pulsfrequenz, so müsste der Prozess nach knapp 2 min unterbrochen werden. Höhere Frequenzen wären dann noch weniger realisierbar mit den existierenden Zündmechanismen. Gegenwärtig werden jedoch kaum Frequenzen über 10 Hz benutzt, zumindest nicht für Beschichtungsprozesse in der Produktion. Der Grund dafür ist, dass die Repetitionsrate der Pulse durch die Ladezeit des Kondensators limitiert wird. Üblicherweise wird nämlich die Dauer (Länge) der Pulse im Verfahren B durch die Kenngrössen einer Kondensatorentladung oder über die Pulsdauerabschaltung in der Funkenstromversorgung eingestellt.

Zusammenfassend lässt sich sagen, dass im Vergleich zueinander die Verfahren A und B sowohl Vorteile als auch Nachteile aufweisen. Beim Verfahren A benötigt es nur eine Initialzündung und dann kann der kontinuierliche Funkenstrom mit Strömen auch sehr hoher Frequenz überlagert werden. Nachteilig kann es aber sein, dass der DC Stromanteil eine Mindestverdampfungsrate festlegt, die die Schichteigenschaften zu stark beeinträchtigt. Nachteilig ist auch die Tatsache, dass die Funkenspannung im Puls nur kurzzeitig zu einer schwer steuerbaren Spannungsüberhöhung führt, die durch die niedrige Impedanz der DC Funkenentladung festgelegt wird. Das beschränkt u.U. die Generierung mehrfach geladener Kohlenstoffionen.

Der Vorteil des Verfahrens B ist die vergleichsweise hohe Spannung beim Zünden des Funkens (positiver Einfluss auf die Generierung mehrfach geladene C-Ionen) und die Möglichkeit, die Funkendauer so einzustellen, dass der Funken (beispielsweise bei Zündung in der Targetmitte) unterbrochen wird, ehe er den Targetrand erreicht und auf andere Materialien überspringt. Die Frequenz der Pulse wird vor allem durch die Schnelligkeit des Zündmechanismus beschränkt. Die meisten Zündverfahren sind jedoch bei hohen Frequenzen und über lange Prozessdauern, wie schon oben diskutiert, unzuverlässig und/oder verursachen unverhältnismässig hohe Kosten.

Nach dem bisher Gesagten wäre also eine Methode wünschenswert, die mit geringem oder ohne DC Stromanteil auskommt, dabei aber hohe Brennspannung im Puls aufweist, bei der zudem mit hohen Frequenzen gearbeitet werden kann und bei der die Pulszündung zuverlässig und mit wenig Aufwand erfolgt.

Die Nachteile bei den verschiedenen Verfahren zur Zündung und zum Betrieb eines kathodischen Funkens auf einem Kohlenstofftarget kann man damit folgendermassen zusammenfassen: Die bisherigen Verfahren bei der Funkenverdampfung basieren entweder auf den mit Pulsen überlagerten DC Funkenstrom oder den durch zusätzliche Zündeinrichtung betriebenen diskontinuierlichen Funken. Die Pulsüberlagerung von Verfahren A führt lediglich zu geringen Spannungsüberhöhungen der Funkenentladung im Pulsanstieg und der damit einhergehenden vergleichsweise geringeren Erzeugung mehrfach geladener Ionen. Die notwendige Ladezeit des Kondensators begrenzt zudem den "duty cycle" des Pulsanteils. Das häufige Zünden beim reinen Pulsbetrieb von Verfahren B reduziert entweder die Zuverlässigkeit des Beschichtungsprozesses und/oder lässt sich nur über sehr teure Lösungen realisieren.

Das Ziel der Erfindung ist es, ein Verfahren für die kathodische Funkenverdampfung von Kohlenstoff anzugeben, mit dem Zündfolgen in sehr hohen Frequenzen und kurzen Pulsdauern realisiert werden können, ohne dass die Einschränkungen des Verfahrens A (ständig unterlagerter Gleichstrom) und des Verfahrens B (Zündung bei jedem Puls) notwendig sind.

Vorzugsweise soll dieses Zündverfahren sich sowohl mit einer "langsamen" Initialzündung, wie sie in dem Verfahren A angewendet werden kann, kombinieren lassen, aber auch mit "schnellen", nicht auf mechanischem Kontakt beruhenden Zündverfahren des diskontinuierlichen Pulsbetriebs wie diese bei Anders et al beschrieben werden.

Die Erfindung soll einen diskontinuierlichen Pulsbetrieb ermöglichen, ohne dass nach der Initialzündung, ein zusätzlicher, quellenfremder Zündmechanismus notwendig ist.

Ein wesentlicher Aspekt der Erfindung ist die Möglichkeit, die Grösse der Entladespannung für die Pulse einzustellen, um dadurch den Ionisierungsgrad des Kohlenstoffdampfes gezielt zu beeinflussen.

Ein weiteres Ziel der Erfindung ist es, ein Beschichtungsverfahren für die Herstellung von Kohlenstoffschichten anzugeben, das ein variables Puls-Pausen-Verhältnis bei der Funkenbeschichtung erlaubt, um damit eine optimale Beschichtungsrateneinstellung am Substrat zu erzielen.

Das erfindungsgemässe Verfahren soll zudem eine Verbesserung des Verfahrens A darstellen, indem es in Kombination mit Mehrfachpulsen bestehend aus einer schnellen Abfolge von Einzelpulsen kurzer Pulszeiten eine Möglichkeit bietet, um die Entladespannung der Funkenentladung gegenüber der Entladespannung bei der herkömmlichen Gleichspannungsfunkenentladung wesentlich heraufzusetzen.

Die Aufgabe wird dadurch gelöst, dass beim kathodischen Funkenverdampfen die Funkenentladung mittels Entladung zumindest eines Kondensators bewerkstelligt wird und der entsprechende Entladestrom in üblicher Weise durch periodisches Zu- und Abschalten des Kondensators gesteuert wird, wobei erfindungsgemäss innerhalb der zugeschalteten Zeitintervallen der Entladestrom bei Erreichen einer vorher festgelegten Grösse kurzzeitig unterbrochen wird. Dies führt innerhalb des Pulses zu weiteren Pulsen, welche im Folgenden als Subpulse bezeichnet werden.

Erstaunlicherweise bedarf es zur Initiierung der Subpulse keinen Gleichspannungsanteil. D.h. innerhalb des Pulses kann die Funkenentladung nach abschalten der Spannung ohne weiteres wieder gestartet werden. Eine von aussen getriggerte Zündung ist nicht notwendig. Ebenso wenig notwendig ist die Aufrechterhaltung des Funkens durch einen Gleichspannungsanteil.

Noch viel erstaunlicher ist allerdings, dass aufgrund der Subpulse nach Ablauf des eigentlichen Pulses, nach Abschalten des Kondensators und nach Ablauf des Ruheintervalls das Zuschalten des Kondensators den erneuten Start der Funkenentladung bewirkt und zwar ohne weiteres, d.h. ohne dass eine von aussen getriggerte Zündung notwendig wäre. Es ist daher auch zwischen den Pulsen kein Grundstrom notwendig. Anders als beim Stand der Technik läuft der Funkenbetrieb erfindungsgemäss mit wesentlichen Unterbrechungen.

Dies hat einerseits den Vorteil, dass durch die Subpulse innerhalb des zugeschalteten Zeitintervalls die Ionisation der verdampften Teilchen signifikant zunimmt. Andererseits hat die Möglichkeit den Funken nach dem Ruheintervall lediglich durch Zuschalten der Entladespannung wieder zu zünden den Vorteil, dass die Beschichtungsrate problemlos begrenzt werden kann und hierdurch weiterhin die Möglichkeit besteht, harte Kohlenstoffschichten mit grossem sp3-Anteil zu realisieren.

Warum das erneute Zünden zu Subpulsen sowie das erneute Zünden nach dem Ruheintervall ohne weiteres möglich ist, ist noch nicht vollständig geklärt. Die Erfinder vermuten allerdings, dass durch den erhöhten Ionisationsgrad der verdampften Teilchen die Zündschwelle so weit herabgesetzt ist, dass bereits eine geringe Spannung ausreicht um den Funken erneut zu zünden. Es wird vermutet, dass dies, eventuell aufgrund der Trägheit der ionisierten Teilchen, insbesondere auch nach Ablauf des Ruheintervalls noch zutrifft. Es muss darauf hingewiesen werden, dass die Frage, wie lange die Ruheintervalle zwischen den Pulsen, in Abhängigkeit von der Pulsdauer und der Anzahl von Subpulsen gewählt werden kann, direkt von der aktuellen Gegebenheit der verwendeten Funkenverdampfungsantage abhängen. Es ist dem Fachmann allerdings ein leichtes experimentell zu ermitteln, bei welcher Ruheintervalldauer der Funken nicht mehr zündet.

Die Erfindung wird anhand von Beispielen und mit Hilfe der Figuren im Detail dargestellt, ohne dass dies die allgemeine erfinderische Idee beschränken soll.

Die Figuren zeigen:
- **Fig. 1:**: Schematische Darstellung des Verfahrens A (Stand der Technik)
- **Fig. 2:**: Schematische Darstellung des Verfahrens B (Stand der Technik)

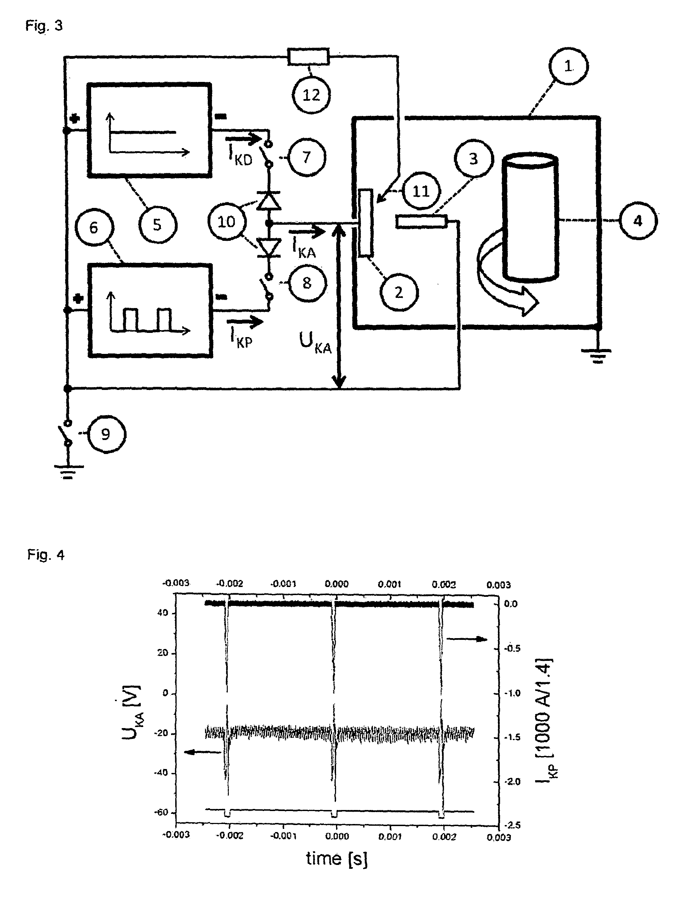

- **Fig. 3:**: Vakuumbeschichtungsanlage und Beschaltung mit den elektrischen Versorgungen
- **Fig. 4:**: Zeitlicher Verlauf von UKA und IKP bei einem Betrieb der Funkenentladung nach Verfahren A gemäss Stand der Technik mit einer Pulsfrequenz von 500 Hz. Als Pulslänge wurde eine Zeit von 100 µs vorgegeben,

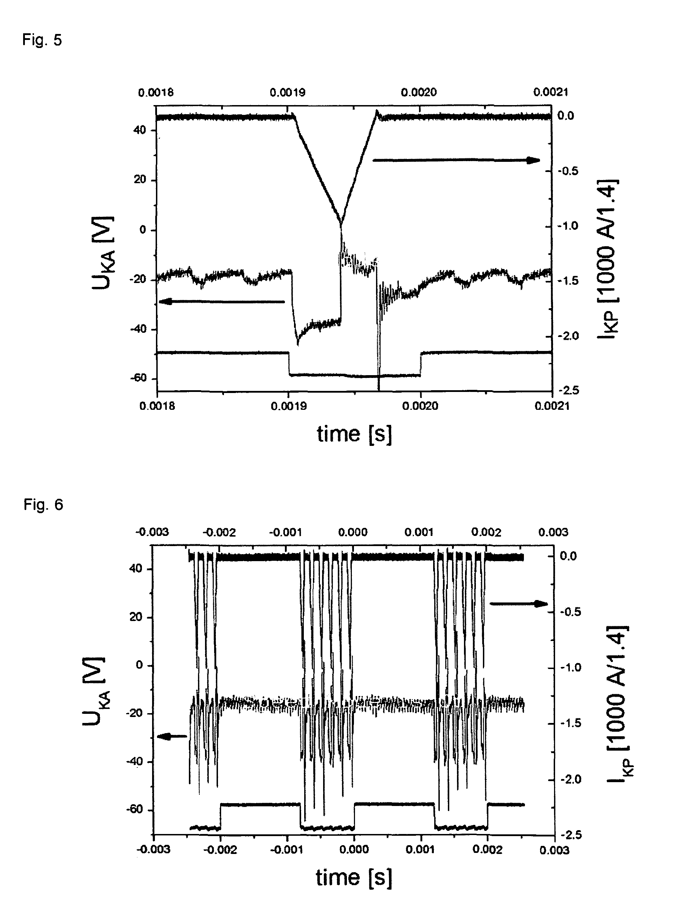

- **Fig. 5:**: Zeitlicher Verlauf von UKA und IKP für einen besser aufgelösten Einzelimpuls bei einem Betrieb der Funkenentladung nach Verfahren A gemäss Stand der Technik mit einer Pulsfrequenz von 500 Hz. Das Triggersignal für den Puls beträgt 100 µs. Der Stromanstieg erfolgt während der vorgegebenen Pulszeit, wobei der Strom schon vor 100 µs die frei wählbare Stromlimitation von ca. 720 A erreicht, was zur Spannungsabschaltung nach ca. 40 µs führt
- **Fig.6:**: Veranschaulichung eines Betriebs bei der gepulsten Funkenentladung (verbessertes Verfahren A). Die Gleichstromversorgung (5) liefert einen IKD von 30 A (nicht gezeigt). Dieser Gleichstromentladung wurden Pulse mit der Pulsstromversorgung (6) überlagert. Der Pulsstrom IKP ist in der Figur dargestellt. Die Pulslänge wurde in diesem Falle auf 800 µs festgesetzt (Triggersignal angegeben). Zwischen den Pulsen wurde eine Pulspause von 1200 µs eingestellt. Die Stromabschaltung erfolgte jeweils bei etwa 700 A. Unter diesen Bedingungen beobachtet man die Entstehung eines Pulsbündels über die Länge des vorgegeben Pulses, das sich jeweils aus 6 Subpulsen zusammensetzt.

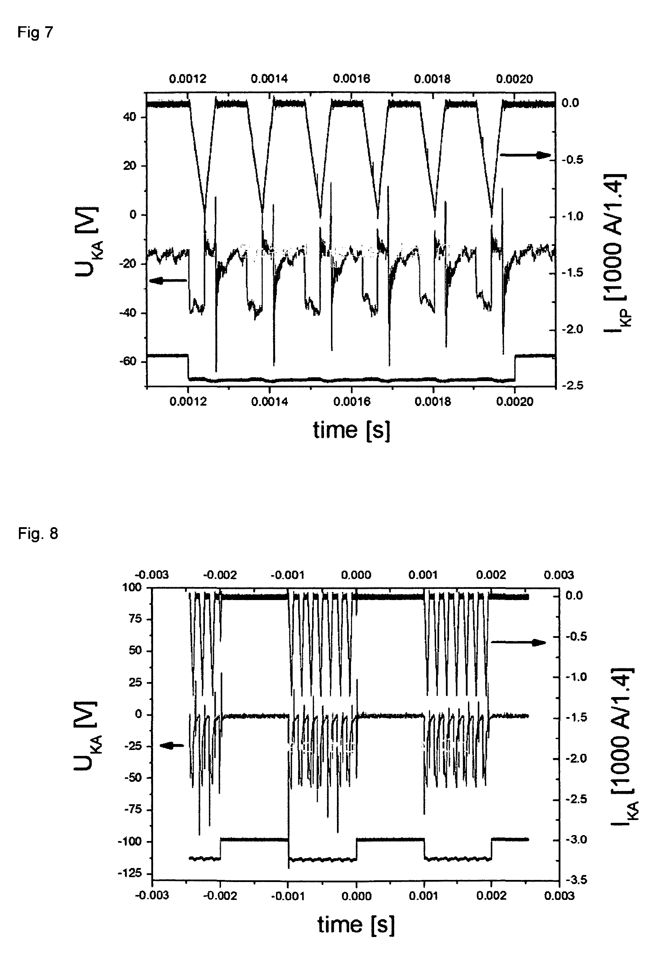

- **Fig. 7:**: Bessere zeitliche Auflösung der Kurven von Figur 6. Die vorgegebene Pulslänge beträgt 800 µs mit einer Stromlimitierung bei etwa 700 A. Es werden in dieser Pulslänge durch die Stromlimitierung 6 Subpulse generiert, wobei in jedem Subpulse die Spannung über ca. 40 µs auf höherem Niveau stabilisiert wird.
- **Fig. 8:**: Erfindungsgemässer Betrieb der gepulsten Funkenentladung. Die Figur zeigt den zeitlichen Verlauf von IKP und UKA für den Fall der ausgeschalteten (entsprechend einem Betrieb mit lediglich diskontinuierlichen Pulsen) Gleichstromversorgung (5). Es wurden Pulslängen von 1000 µs vorgegeben und Pulspausen von ebenfalls 1000 µs.

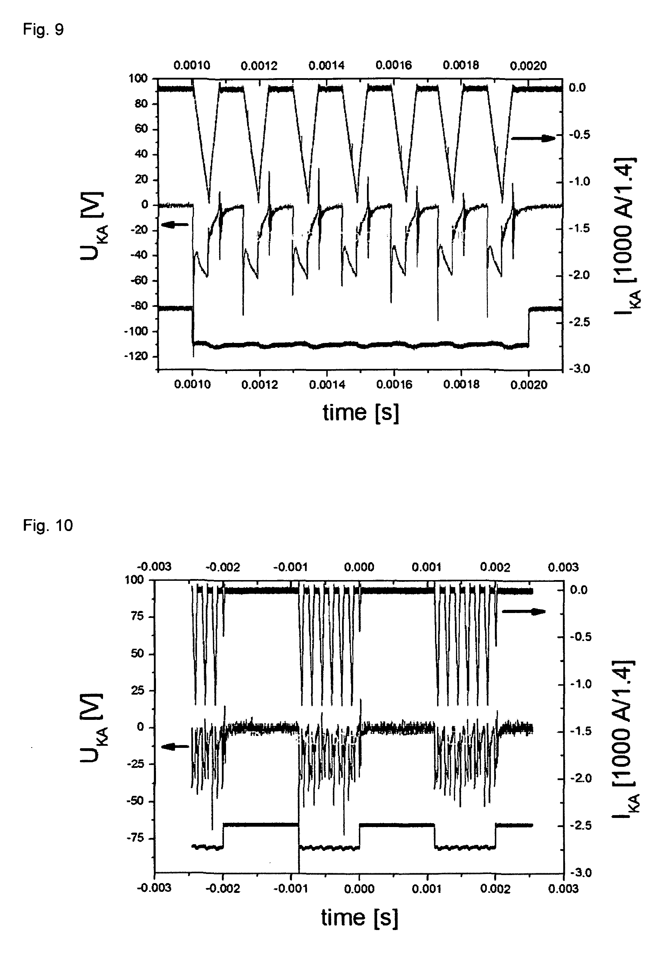

- **Fig. 9:**: Bessere zeitliche Auflösung von Figur 8. Es wird ein Einzelimpuls mit 7 Subpulsen gezeigt. Aus der Kurve geht hervor, dass Zündspannungen um die 60 V ausreichen, um neuerlich die Subpulse innerhalb des Einzelpulses zu zünden, ohne dass es zusätzliche Zündeinrichtungen benötigt. Erstaunlicherweise genügen diese Spannungen auch, um nach 1000 µs die Einzelimpulse wieder zu zünden.
- **Fig. 10:**: Die Figur zeigt den zeitlichen Verlauf für UKA und IKP (erfindungsgemäss ohne Gleichstromunterlagerung) für eine vorgegebene Pulsdauer von 900 µs, in dessen Verlauf 6 Subpulse generiert werden. Als Pulspause wurde eine Zeit von 1100 µs gewählt. Für diesen Fall konnte der Zündbetrieb mit den rein diskontinuierlichen Pulsen gerade noch realisiert werden. Für kleinere Pulslängen und längere Pulspausen in dieser experimentellen Konfiguration konnte die Zündung nicht mehr sicher gewährleistet werden.

In den Figur 4 bis 6 sind jeweils 3 Kurven dargestellt. Die oberste Kurve entspricht dem Stromverlauf. Entsprechend ist die rechte Achse relevant. Die mittlere Kurve entspricht dem Spannungsverlauf. Entsprechend ist die linke Achse relevant. Die unterste Kurve soll lediglich die Pulsdauer anzeigen. Deren Amplitude ist in zufälligen Einheiten gewählt.

Die Versuche wurden auf einer Vakuumbeschichtungsanlage des Typs Innova der Firma OC Oerlikon Balzers AG durchgeführt. Die Übertragbarkeit der Methode auf andere Vakuumbeschichtungsanlagen wird dem Fachmann durch die Beschreibung ersichtlich werden.

Die Vakuumbeschichtungsanlage ist schematisch in Figur 3 dargestellt und umfasst einen evakuierbaren Rezipienten 1, in dem sich ein drehbarer Substrathalter 4 zur Aufnahme der zu beschichtenden Substrate befindet. Bei allen Versuchen wurde in den evakuierten Rezipienten Argongas mit einem Fluss von 200 sccm eingelassen, wobei sich ein Totaldruck im Rezipienten von 0.6 Pa einstellte. Der Druckbereich des Argongases kann in weiten Bereichen variiert werden und es können auch andere Gase, beispielsweise Stickstoff verwendet werden.

Weiter befindet sich in diesem evakuierbaren Rezipienten eine Funkenverdampfungsquelle, die das zu verdampfende Target 2 aus Kohlenstoff enthält. Das Target 2 ist entsprechend mechanisch gehaltert und isoliert vom Rezipienten 1, welcher auf Masse liegt angebracht. Es wird als Kathode der Funkenentladung geschaltet. Zusätzlich befindet sich in dem Rezipienten eine Anode 3, die bevorzugt in der Nähe des kathodisch betriebenen Targets 2 angebracht ist. Die räumliche Nähe der Anode 3 zum Target 2 erleichtert den Funkenbetrieb, vor allem den Zündvorgang bei den diskontinuierlichen Pulsfolgen mit "Eigenzündung" oder ohne zusätzliche Fremdzündung. Die zentrische Anordnung der Anode 3 trägt auch zur Stabilität des Funkens bei, weil sie den Zündvorgang vor allem in der Targetmitte fördert und verhindert, dass der Funken zum Targetrand läuft. Das Pulsen des Funkenstromes trägt auch zur Stabilisierung der Funkenentladung bei. Einmal, weil es das Verharren des Funkens auf einem Fleck des Targets verhindert, aber auch, und das besonders bei dem diskontinuierlichen Funkenbetrieb, weil es, bevorzugt durch die zentrische Platzierung der Anode 3 bezüglich des Targets 2, die Funkenzündung in der Targetmitte fördert und der Funkenstrom unterbrochen werden kann (über das Einstellen der Pulslänge), ehe der Funken den Targetrand erreichen kann. Zur kathodischen Funkenverdampfung des Targets 2 werden zwei elektrische Versorgungen verwendet, deren Funktionen selbstverständlich auch innerhalb einer Versorgung ausgebildet sein können. Die Gleichstromversorgung 5 stellt eine Stromspeisung dar mit einer Leerlaufspannung von typisch 100 V. Im Funkenbetrieb stellt sich diese Spannung wegen der geringen Impedanz der Funkenentladung (kleiner 1 Ohm) auf Spannungen unter 50 V, typischerweise beim Kohlenstofftarget auf Spannungen um die 20 V ein. Bei solchen Stromspeisungen können typische Ströme bis ca. 1000 A eingestellt werden. In den hier beschriebenen Experimenten wird aber bevorzugt nur der Strombereich um 100 A und darunter benutzt, weil ja, wie oben schon bemerkt, zu hohe Beschichtungsraten die Härte der Kohlenstoffschichten reduzieren. Die gepulste elektrische Versorgung 6, die im Wesentlichen eine Kondensatorentladung schaltet ist mit ihren elektronischen Bauelementen so ausgelegt, dass sie hohe Entladeströme schalten kann. Deshalb kann es sinnvoll sein, die elektronischen Bauelemente (z.B. IGBT) so zu dimensionieren, dass man ein Optimum zwischen gefordertem Entladestrom und Schaltfrequenz anstrebt. Die Grösse des Kondensators wird so gewählt, dass man bei gegebener Ladespannung am Kondensator genügend Energie (Q=CU) speichern kann, um damit den kathodischen Funken zu speisen oder, in anderen Worten, das entsprechende Kathodenmaterial (hier Kohlenstoff) zu verdampfen. Die Auslegung der gepulsten elektrischen Versorgung ist also ein Kompromiss zwischen Pulsstrom, Pulsfrequenz, Ladespannung und zur Verfügung gestellter Kondensatorkapazität. Mit den Schaltern 7 und 8 können die elektrischen Versorgungen zum Betrieb der Funkenentladung an das Target angeschlossen werden.

Auch kann, und das ist neu und ein Teil der Erfindung, die Funkenentladung nach einer Initialzündung allein durch die gepulste elektrische Versorgung gespeist betrieben werden, nämlich nur mit dem Pulsstrom IKP. Der gesamte Funkenstrom IKA ist dann identisch mit IKP. Die Entladespannung der Funkenentladung UKA wird zwischen Kathode (Target 2) und Anode 3 gemessen wie es in Figur 3 dargestellt ist. Falls man die Funkenentladung allein mit der gepulsten Versorgung betreiben wollte, musste beim bisherigen Stand der Technik bei jedem Puls immer wieder neu gezündet werden Durch das erfindungsgemässe Verfahren wird dieses immer wieder neue Zünden unnötig.

Die Versorgungen sind jeweils mit Dioden 10 abgesichert, die verhindern, dass der gelieferte Strom von einer Versorgung in die andere gespiesen wird und dadurch Schäden entstehen. Üblicherweise werden die positiven Ausgänge der Versorgungen auf Masse gelegt, also auf das Potential, auf dem sich auch der Rezipient befindet. Es kann aber auch vorteilhaft sein, dass die Funkenentladung floatend (potentialfrei) betrieben wird. Zu diesem Zweck wird der Schalter 9 geöffnet. Abhängig von der Schalterstellung wird also die Anode potentialfrei oder auf Massepotential (gleiches Potential wie der Rezipient) betrieben. Zur Initialzündung der Funkenentladung wurde in den Experimenten ein mechanischer Zündkontakt 11 benutzt, der über einen niederohmigen Widerstand kurzzeitig einen Kontakt mit Anode herstellt und damit zu einer initialen Verdampfung des Targetmaterials führt, welches dann die Strecke Kathode-Anode leitfähig macht, damit die elektrischen Versorgungen 5 oder/und 6 die Funkenspeisung zur Verdampfung des Targetmaterials übernehmen, d.h. diese bei kleineren Spannungen betrieben werden. Nach der Initialzündung wird erfindungsgemäss die elektrische Gleichspannungsversorgung 5 beispielsweise über Schalter 7 abgeschaltet. Der Funken wird nun ausschliesslich durch die gepulste elektrische Versorgung 6 ohne Gleichstromanteil gespiesen.

In der Literatur wurde für den diskontinuierlichen Pulsbetrieb (Verfahren B) gezeigt, dass eine Überhöhung des Stromes am Anfang des Pulses zur Erhöhung des Anteils mehrfach ionisierter Ionen des verdampften Targetmaterials (Paperny et al., "Ion acceleration at different stages of a pulsed vacuum arc", J. Phys. D: Appl. Phys. 42 (2009) 155201) beiträgt. Leider wurde nicht auf den Spannungsverlauf bei diesen Experimenten eingegangen. Vermutlich ist die Ursache für die Überhöhung des Stromes beim Pulsanfang auf das kurzzeitige Anliegen einer höheren Spannung zurückzuführen, d.h. dass möglicherweise die Spannungsüberhöhung als eigentliche Ursache für die erhöhte Ionisierung zu betrachten wäre und die Stromzunahme lediglich einen sekundären Effekt darstellt.

Im Verfahren B lässt sich eine erhöhte Funkenspannung dadurch realisieren, dass der Funken unter der Voraussetzung gezündet wird, dass zwischen Kathode und Anode eine hohe Leerlaufspannung angelegt wird. Das kann beispielsweise dadurch geschehen, dass der Kondensator, der zur Entladung im Puls benutzt wird, auf eine hohe Spannung aufgeladen wird und von dieser hohen Leerlaufspannung am Kondensator ausgehend der Funken durch eine weitere kurzzeitige Verdampfung von Material gezündet wird. Nach der Zündung entlädt sich dann der Kondensator, solange dessen Ladung ausreicht, um den Funken zu unterhalten. Unmittelbar nach der Zündung (typischerweise innerhalb der ersten 50 µs) verläuft dann die Funkenentladung bei erhöhter Spannung und fällt anschliessend wieder auf einen tieferen Spannungswert ab, der typischerweise durch die Impedanz der jeweiligen Gleichstromfunkenentladung gegeben ist.

Die Erzeugung der Ionen höherer Ladungszustande erfolgt beim gegenwärtigen Wissensstand (Paperny et al.) im Anfang des Strompulses und verliert sich dann nach diesem, sodass bei einer Pulslänge von 200 µs nach den ersten 50 µs lediglich nur noch Ladungszustände generiert werden, wie sie für die Gleichstromfunkenentladung typisch sind. Um also höhere Ladungszustände zu generieren, ist es wichtig, kurze Strompulse in der Grössenordnung unter 100 µs, bevorzugt unter 50 µs zu erzeugen. Bei typischen Pulsfrequenzen von 1 kHz würde das eine merkliche Reduktion des "duty cycle" bedeuten und zu sehr kleinen Beschichtungsraten führen. Eine schnellere Fremdzündung durch Materialverdampfung ist an das Ladungsverhalten des zu benutzenden Kondensators (Kapazität des Kondensators muss gross genug sein, um Materialplasma zum Zünden zu generieren) gekoppelt und liegt (siehe Anders et al.) in guten Fällen ebenfalls bei 1 ms Ladezeit, also etwa bei der Frequenz von 1 kHz. Denkbar wäre eine, wenn auch aufwendige, Möglichkeit, mehrere Zündkondensatoren zeitlich aneinander zu koppeln, um Pulsfolgen höherer Frequenz zu erhalten. Das ist aber umständlich und teuer und wurde nach Wissen der Erfinder bisher auch noch nicht verfolgt. Die Erhöhung der Pulsfrequenz, vor allem für kurze Pulse und im diskontinuierlichen Betrieb, ist ein weiterer Aspekt, der durch die Erfindung gelöst wird.

Während also eine Stromerhöhung am Pulsanfang für das Verfahren B verhältnismässig einfach zu realisieren ist und lediglich wegen der hohen Spannung am Zündmechanismus komplex sein kann, lassen sich hohe Funkenspannungen schwieriger beim Verfahren A realisieren. Dem Fachmann ist bekannt, dass eine allmähliche Spannungssteigerung bei der Gleichstromfunkenentladung in einer Stromerhöhung "ohne Grenzen" resultiert, ohne dass sich eine merkliche Spannungsüberhöhung einstellt. Lediglich die Überlagerung des Gleichstromes durch sehr steile Pulse erhöht die Spannung der Funkenentladung beim Verfahren A. Diese Spannungserhöhung über längere Zeiten zu stabilisieren ist schwierig, da der Strom schnell ansteigt und es zu einer schnellen Entladung des Kondensators kommt mit dem damit zusammenhängenden Zerfall der Spannung am Kondensator selbst. Das gilt besonders für den Fall des unterlagerten Gleichstromes, da eine Gleichstromfunkenentladungen kleine Impedanzen im Bereich von nur etwa 0.1 Ohm aufweist.

Die erfindungsgemässen Verfahren berühren auch noch einen weiteren Aspekt der kathodischen Funkenverdampfung von Kohlenstoff. Aus den Untersuchungen von Horikoshi et al., "Vacuum Arc Deposition of Homogeneous Amorphous Carbon Films at High Growth Rates", New Diamond and Frontier Carbon Technology, Vol. 16, No. 5 (2006), 267-277 kann man schlussfolgern, dass die Entladespannung am Kondensator und die Grösse der Ladung bei der Kondensatorentladung die Spritzerhäufigkeit bei der kathodischen Funkenverdampfung beeinflusst, und zwar je höher die Entladespannung und je grösser die Ladungsmenge bei der Entladung, umso geringer die Spritzerzahl. Das wurde an Einzelstrompulsen nach Verfahren B nachgewiesen. Die dabei aufgezeichneten Pulsformen (Figure 4 in Horikoshi et al.) stellen den typischen Strom-Zeit-Verlauf für eine Kondensatorentladung dar: anfangs steiler Stromanstieg bis auf ein Maximum, das typisch innerhalb der ersten 100 µs erreicht wird, und dann langsamerer Stromabfall. Die Pulslänge hängt von der Kapazität und der Impedanz der Entladung ab. Auch Entladespannung und Ladung beeinflussen die Pulsform.

Die hier beschriebenen Experimente wurden mit einer gepulsten elektrischen Versorgung 6 durchgeführt, die auf einer gesteuerten Kondensatorentladung beruht und die in diesem speziellen Falle Pulsfrequenzen bis 2 kHz bei maximalen Entladeströmen von 1000 A zuliess. Der Kondensator hatte eine Kapazität von 8 mF und es konnten Spannungen bis 1000 V zur Ladung des Kondensators benutzt werden. Die Vergrösserung des Kondensators lässt ohne weiteres auch Ströme von 2000 A oder mehr zu und es können beispielsweise auch Ladespannungen bis 2000 V benutzt werden. Die Ladezeit des Kondensators ist proportional zum Produkt von R und C, wobei R der ohmsche Widerstand im Ladekreis ist und C die Kapazität des Kondensators. Falls man also Kondensatoren mit grossen Kapazitäten C laden möchte, so ist man gezwungen entweder lange Ladezeiten in Kauf zu nehmen oder grosse Ladespannungen zu benutzen, um bei kleineren Ladezeiten auf die gleiche Ladungsmenge am Kondensator zu kommen. Höhere Ladespannungen stossen an die Verträglichkeitsgrenzen der elektronischen Bauelemente und längere Ladezeiten limitieren die Pulsfrequenz (Anders et al.). Die Benutzung höherer Ladespannungen wird zudem noch eingeschränkt durch die Strombegrenzung der Gleichspannungsversorgung, die zum Laden des Kondensators benutzt wird (diese ist entweder in der Versorgung 6 integriert oder wird als externe Versorgung an 6 angeschlossen und ist in der Figur nicht getrennt aufgeführt). All diese Tatsachen haben bisher verhindert, dass bei erhöhten Funkenspannungen über längere Pulszeiten und bei höheren Frequenzen kathodische Funkenentladungen zum Zwecke der Materialverdampfung, speziell zum Zwecke der Verdampfung von Kohlenstoff durchgeführt werden konnten.

Zuerst soll eine Methode beschrieben werden, die zu einer Verbesserung des Verfahrens A führt. Bei diesem bereits in der Schrift von Grimm EP_00666335_A1 beschriebenen Verfahren wird eine Gleichstromfunkenentladung über einen kurzzeitigen Kontakt des mechanischen Zündfingers (Anode) mit dem Target gezündet, die dann über die Versorgung 5 weiter unterhalten wird. Zusätzlich werden dieser Gleichstromentladung dann noch Strompulse aus einer Kondensatorentladung (Versorgung 6) überlagert. Der zeitliche Stromverlauf dieser Pulse unterscheidet sich nicht wesentlich von denen die auch bei Horikoshi et al. angegeben wurden: Anstieg des Strompulses am Anfang und dann Abfall bedingt durch Entladung des Kondensators und in Abhängigkeit der jeweiligen Impedanz.

Diese ist im Falle der Gleichstromunterlagerung in der Grösse von 0.1 Ohm, d.h. der Kondensator wird schnell entladen (Zeitkonstante RxC).

Der zeitliche Verlauf der Spannung UKA und des Stromes IKP für einen solchen Betrieb ist in Figur 4 dargestellt. Der Strom IKD (nicht dargestellt) wurde auf 30 A mit Versorgung 5 vorgegeben. Gewöhnlich fällt dieser Strom während des Pulses aus Versorgung 6 zusammen, da die Diode den Strom IKD dann sperrt. Es wurden Pulse mit einer Frequenz von 500 Hz generiert und eine Pulslänge von 100 µs und eine Pause zwischen den Pulsen von 1900 µs vorgegeben. Im Pulsverlauf kommt es sowohl zu einer Spannungs- wie auch Stromüberhöhung, die mit verbesserter Zeitauflösung in Figur 5 deutlicher für einen der mit 100 µs vorgegebenen Pulse dargestellt ist. Daraus geht hervor, dass sich die Spannung zu Beginn des Pulses von -20 V, der Spannung, die sich im Gleichstromfall mit der elektrischen Versorgung (5) einstellt, auf etwa -50 V verändert und sich anschliessend bei etwa -40 V stabilisiert. Resultat dieser betragsmässigen Spannungserhöhung ist ein starker Stromanstieg. Würde man nun nach der bisherigen Betriebsweise bei Verfahren A vorgehen (Schrift von Grimm EP_00666335_A1) vorgehen und der Kondensatorentladung freien Lauf lassen, so stiege der Strom noch weiter an, der Kondensator würde sich schnell entladen und die Spannung fiele mit dem Stromanstieg ab (Abfluss der Ladungen vom Kondensator). Die Spannung würde sich also stark zeitlich ändern.

Um höhere Entladespannung zu stabilisieren, wird deshalb die Grösse des Funkenstromes limitiert, noch bevor sich die Spannung am Kondensator zu stark verringert. Das wird anhand der Figur 5 erläutert. An der Versorgung 6 kann eine Pulslänge vorgegeben werden, die die Entladungszeit begrenzt und für die in diesem Falle 100 µs gewählt wurden. Zum besseren Verständnis wurde das Triggersignal für den Puls ebenfalls in die Figur 5 eingezeichnet (unterste Kurve). Für den Pulsstrom wurde eine obere Grenze von 720 A vorgegeben (in der Figur entsprechen 1.4 V etwa 1000 A). Die Begrenzung des Stromes wurde so vorgenommen, dass die Spannung der Funkenentladung zeitlich in bestimmten Grenzen stabil gehalten werden konnte oder mit anderen Worten: die Stromabschaltung erfolgte bei einem Stromwert, bei dem die Spannung noch nicht wesentlich zusammengefallen war. Das hängt von den jeweiligen experimentellen Bedingungen ab (also beispielsweise auch Kabelinduktivitäten) und den technischen Daten der verwendeten Versorgung 6 und den Eigenschaften der Gleichstromfunkenentladung. Experimentell lässt sich diese Strombegrenzung aber leicht mittels eines Oszilloskops ermittelten, das die zeitlichen Strom- und Spannungsverläufe anzeigt.

Die Figur 5 zeigt insbesondere, dass der Strom (oberste Kurve in Figur 5) diesen Grenzwert schon vor der Pulsdauer von 100 µs erreicht und dass man mit dieser Methode der früheren

Stromabschaltung vor dem Spannungszerfall die höhere Spannung UKA über ca. 40 µs stabilisieren kann, d.h. in dem Bereich, in dem man die höheren Ladungszustände des Kathodenmaterials generiert.

Es hat sich gezeigt, dass die Spannungsüberhöhung von der Ladespannung des Kondensators abhängt (hier wurden 300 V benutzt), aber auch von der Grösse des Kondensators, der geladen werden muss (hier 8 mF). Dadurch, dass in diesem Experiment eine Gleichspannungsversorgung zur Ladung des Kondensator benutzt wurde, bei der der maximale Strom auf 30 A begrenzt war und mit einer Pulsfrequenz von 500 Hz gearbeitet wurde, kann die Kapazität zwischen den Pulsen nicht wieder vollständig geladen werden. Das wird nur deshalb erwähnt, weil gezeigt werden soll, dass das Verfahren auch unter solchen Einschränkungen funktioniert.

Figur 6 veranschaulicht nun einen Betrieb bei der gepulsten Funkenentladung. In diesem Falle wird wieder mit einer Gleichstromversorgung 5 gearbeitet, die einen IKD von 30 A liefert. Dieser Gleichstromentladung werden nun Pulse mit der Pulsstromversorgung 6 überlagert. Der Pulsstrom IKP ist in der Figur 6 dargestellt. Die Pulslänge wurde in diesem Falle auf 800 µs festgesetzt (Triggersignal angegeben). Zwischen den Pulsen wurde eine Pulspause von 1200 µs eingestellt. Zur Stromabschaltung wurde wieder der Maximalstrom auf etwa 700 A begrenzt. Unter diesen Bedingungen beobachtet man nun die Entstehung eines Pulsbündels über die Länge des vorgegeben Pulses, das sich jeweils aus 6 Subpulsen zusammensetzt. Zur Verdeutlichung wurde eine bessere zeitliche Auflösung in Figur 7 gewählt. Daraus ersieht man, dass, falls man wieder mit der Strombegrenzung arbeitet, die Generierung der Subpulse die Entladespannung ähnlich wie für die Bedingungen in Figur 5 auf Werte von etwa -40V festlegen kann, wiederum über etwa 40 µs, also für die Zeitdauer eines Subpulses. Die Zeitkonstante für das erneute Zuschalten der Subpulse beträgt etwa 100 µs. Diese ist bedingt durch das Kommutierungsverhalten der Schutzdioden und kann verkürzt werden durch schnellere Dioden. In Figur 7 sieht man auch, dass in einem vorgegebner Puls von 800 µs und einer Stromlimitierung bei 700 A, 6 Subpulse generiert werden können mit einer Sequenz der Subpulse, die grösser ist, als die von der ursprünglichen Versorgung mögliche (hier um etwa einen Faktor 7.5 grösser). Gleichzeitig kann in dem 800 µs langen Puls durch die Erzeugung von 6 Subpulsen die Spannung über eine Zeit von 6x40 µs, also insgesamt über 240 µs stabilisiert werden.

Für das Verfahren A kann also mit dieser Methode sowohl die Pulsfrequenz vergrössert als auch die Funkenentladung auf einer höheren Spannung stabilisiert werden. Wichtig ist aber vor allem die Möglichkeit, dass man mit diesem Verfahren das Verhältnis von

Gleichstromanteil zu Pulsstromanteil zugunsten des Pulsstromanteils über weite Bereiche einstellen kann. In Figur 4 wird mit IKD von 30 A gearbeitet und mit einem zeitlichen Mittel von IKP von 12 A. Dahingegen wird in Figur 6 bei gleichem Gleichstromanteil mit einem zeitlich gemittelten IKP von 70 A gearbeitet.

Wünschenswert wäre nun die Generierung eines Bündels von Subpulsen im Verfahren B. Damit liesse sich der Gleichstromanteil ganz vermeiden. Bei diesem Verfahren, das auf diskontinuierlichen Pulsen beruht, ist man mit dem Problem des Zündens bei jedem Puls, aber noch mehr mit dem Problem des in viel höherer Sequenz zu erfolgenden Zündens der einzelnen Subpulse konfrontiert. Mit Zündmechanismen des gegenwärtigen Standes der Technik kann dieses Problem nicht gelöst werden.

Es wurde deshalb versucht, ob die Kombination Funkenstrombegrenzung, erhöhter Entladespannung und höherer Sequenz bei den so erzeugten Subpulsen genügend und genügend lang leitfähiges Plasma erzeugen kann, um von einer Fremdzündung abzusehen, ausgenommen lediglich einer einmaligen Initialzündung über 5 in Verbindung mit dem mechanischen Zündfinger 11.

Zu diesem Zwecke wurde wie folgt vorgegangen. In einem ersten Schritt wurde durch den kurzzeitigen Kontakt zwischen Zündfinger 11 und Target 2 eine Gleichstromfunkenentladung mit einem Strom IKD von 40 A gezündet. Dann wurde, analog zu Verfahren A, die gepulste Versorgung zugeschaltet und ein Pulsstrom IKP dem Gleichstrom IKD überlagert. Als weiterer Schritt wurde die Gleichstromversorgung 5 ausgeschaltet. In Figur 8 ist nun der zeitliche Verlauf von IKP und UKA dargestellt für den Fall der ausgeschalteten (entsprechend einem Betrieb mit lediglich diskontinuierlichen Pulsen) Gleichstromversorgung 5. Es wurden Pulslängen von 1000 µs vorgegeben und Pulspausen von ebenfalls 1000 µs. Überraschenderweise konnte mit einer solchen Betriebsweise sichergestellt werden, dass es keine neuerliche Zündung zwischen den Subpulsen innerhalb des Pulsbündels, aber auch, was noch überraschender war, zwischen den Einzelpulsen benötigte. Aus der Figur 9, die in besserer zeitlicher Auflösung einen Einzelimpuls mit 7 Subpulsen zeigt, geht hervor, dass Zündspannungen mit dem Betrag um die 60 V ausreichen, um neuerlich die Subpulse innerhalb des Einzelpulses zu zünden, ohne dass es zusätzliche Zündeinrichtungen benötigt. Erstaunlicherweise genügen diese Spannungen auch, um nach 1000 µs die Einzelimpulse wieder zu zünden. Damit liefert das Verfahren eine Methode, mit der sich der diskontinuierliche Pulsbetrieb ohne zusätzliche Zündeinrichtung realisieren lässt. Darüber hinaus kann auch die Sequenz der Subpulse innerhalb der Einzelimpulse heraufgesetzt werden, im vorliegenden Fall auf etwa 7 kHz.

Der Grund dafür, dass diese sowohl schnelle wie einfache Methode des Funkenzündens funktioniert, ist nicht vollständig geklärt. Es wird angenommen, dass das Gemisch aus Argongas und verdampften Kohlenstoffs in Verbindung mit der intensiven Ionisierung durch den Pulsbetrieb (hohe Elektronenströme) ausreichen, um genügend lang ein gut leitfähiges Plasma zu bilden, in dem die Funkenentladung bei kleinen Spannungen wieder gezündet werden kann. Um für die in diesen Experimenten verwendeten Vorrichtung und die speziellen Prozessparameter die Grenze für das gerade noch realisierbare Zünden abzuschätzen, wurde der Einzelimpuls kürzer und die Pulspause länger eingestellt. In Figur 10 ist ein Puls von 900 µs Dauer dargestellt, in dessen Verlauf 6 Subpulse generiert werden. Als Pulspause wurde eine Zeit von 1100 µs gewählt. Für diesen Fall konnte der Zündbetrieb mit den rein diskontinuierlichen Pulsen gerade noch realisiert werden. Für kleinere Pulslängen und längere Pulspausen konnte die Zündung nicht mehr sicher gewährleistet werden. Es ist dem Fachmann jedoch einleuchtend, dass veränderte Kapazitäten, andere Stromabschaltlevel, verschiedene (oder keine) Gasflüsse, andere Spannungen am Kondensator usw. diese Grenzen des selbständigen Zündens beeinflussen und leicht für die jeweiligen experimentellen Anordnungen eingestellt werden können.

Das erfindungsgemässe Verfahren wurde für die kathodische Funkenverdampfung von Kohlenstoff beschrieben, weil es bei diesem Material besonders schwierig ist, den kathodische Funken zu betreiben, d.h. das "Festfressen" an einer Targetposition zu verhindern. Das Verfahren kann aber ebenso vorteilhaft für andere Materialien benutzt werden. Das können sowohl elementare metallische Targets sein oder aber auch Targets bestehend aus mehreren Materialien wie beispielsweise pulvermetallurgisch hergestellte Targets. Besonderen Vorteil bietet das Verfahren für Materialien mit niedrigem Schmelzpunkt, weil auch hier der Pulsbetrieb die Spritzerbildung verringert. Auch für reaktive Prozesse in Gasen die Sauerstoff, Stickstoff oder Kohlenstoff enthalten, lässt sich dieses Verfahren mit Vorteil zur Erhöhung der Ionisierung und zur Reduktion der Spritzerbildung anwenden.

Durch die zentrisch zum Target angeordnete Anode und das Pulsen des Funkenstroms, vor allem im diskontinuierlichen Betrieb, kann eine stabile Funkenentladung garantiert werden.

Der diskontinuierlichen Pulsbetrieb erlaubt ebenfalls die kathodische Verdampfung von Kohlenstofftargets mit metallischen Anteilen bis zu 50 at.%.

Die Methode der Verteilung der Einzelpulse auf Bündel von Subpulsen höherer Sequenz und über längere Zeiten erlaubt eine diskontinuierlichen Pulsbetrieb ohne zusätzliche Fremdzündung, sowohl zwischen den dichter beieinander liegenden Subpulsen als auch zwischen den Einzelpulsen.

Die Spannung am Kondensator (Versorgung 6) kann in weiten Grenzen verändert werden zum Zwecke der Erzeugung höher geladener Ionen des in der kathodischen Funkenentladung verdampften Materials.

Die höhere Entladespannung in Kombination mit einer schnellen aber stromlimitierten Entladung reduziert die Spritzerhäufigkeit in den synthetisierten Kohlenstoff- oder kohlenstoffhaltigen Schichten.

Das Verfahren stellt einen diskontinuierlichen Pulsbetrieb einer Funkenentladung dar, ohne dass neu gezündet werden muss.

Aufgrund des Verfahrens wird kein DC Haltestrom für die Funkenentladung benötigt.

Im Rahmen dieser Beschreibung wurde ein Verfahren zum Betreiben einer gepulsten diskontinuierlichen Funkenentladung offenbart die mittels Entladung zumindest eines Kondensators bewerkstelligt wird und der entsprechende Entladestrom durch periodisches Zu- und Abschalten des Kondensators gesteuert wird, wobei bei abgeschaltetem Kondensator während der abgeschalteten Zeitintervalle kein Strom aus der Versorgung geliefert wird und innerhalb der zugeschalteten Zeitintervallen der Entladestrom bei Erreichen einer vorher festgelegten Grösse kurzzeitig unterbrochen wird und dies innerhalb des Pulses zu Subpulsen führt.

Vorzugsweise wird eine erste Vielzahl der abgeschalteten Zeitintervalle so kurz gewählt, dass nach deren jeweiligen Ablauf das Zuschalten des Kondensators ohne weiteres das erneute Zünden der Funkenentladung bewirkt.

Vorzugsweise wird die erste Zündung der Funkenentladung mittels einer Zündvorrichtung, besonders bevorzugt mittels einer DC-Gleichspannungsquelle bewerkstelligt und nach Zünden des Funkens der Kondensator erstmals zugeschaltet. Der Kondensator hat vorzugsweise zum Zeitpunkt des erstmaligen Zuschaltens mittels Mitteln zum Laden einen ersten Ladungszustand und die Funkenentladung wird anschliessend bei abgeschalteter DC-Gleichspannungsquelle weiter betrieben.

Es kann eine zweite Vielzahl der abgeschalteten Zeitintervalle in Abhängigkeit der Mittel zum Laden des zumindest einen Kondensators geben die so lange gewählt werden, dass der Kondensator nach Ablauf der zweiten Vielzahl der abgeschalteten Zeitintervalle im Wesentlichen den ersten Ladezustand erreicht hat.

Die oben beschriebene Funkenentladung kann zum Betreiben einer kathodischen Funkenverdampfung eingesetzt werden.

Es wird eine Verfahren zum Beschichten von Substraten beschrieben, welches folgende Schritte umfasst:
- Bereitstellen von Substraten
- Einbringen der Substrate in eine Vakuumkammer
- Abpumpen der Vakuumkammer
- Durchführung einer kathodischen Funkenverdampfung oben beschriebener Art

Mittels dieses Beschichtungsverfahrens können wasserstofffreie und/oder wasserstoffhaltige und/oder metallfreie und/oder metallhaltige Kohlenstoffschichten hergestellt werden.

### Bezugszeichenliste

- 1: Rezipient
- 2: Target (Kathode)
- 3: Anode (bevorzugt, aber nicht notwendig zentrisch zum Target)
- 4: Substrathalterung (rotierend)
- 5: Gleichstrom(funken)versorgung
- 6: Pulsstrom(funken)versorgung
- 7: Schalter zum Schalten von IKD
- 8: Schalter zum Schalten von IKP
- 9: Schalter, um Anode auf Masse oder auf Schwebepotential zu schalten
- 10: Schutzdioden
- 11: Mechanischer Zündfinger
- 12: Widerstand zur Strombegrenzung zwischen Zündfinger und Anode

## Patentansprüche

1. Verfahren zum Betreiben einer gepulsten diskontinuierlichen Funkenentladung, die mittels Entladung zumindest eines Kondensators bewerkstelligt wird und der entsprechende Entladestrom durch periodisches Zu- und Abschalten des Kondensators gesteuert wird, wobei bei abgeschaltetem Kondensator während der abgeschalteten Zeitintervalle kein Strom aus der Versorgung geliefert wird, **dadurch gekennzeichnet, dass** innerhalb der zugeschalteten Zeitintervallen der Entladestrom bei Erreichen einer vorher festgelegten Grösse kurzzeitig unterbrochen wird und dies innerhalb des Pulses zu Subpulsen führt.

2. Verfahren nach Anspruch 1, **dadurch gekennzeichnet, dass** zumindest eine erste Vielzahl der abgeschalteten Zeitintervalle so kurz gewählt werden, dass nach deren jeweiligen Ablauf das Zuschalten des Kondensators ohne weiteres das erneute Zünden der Funkenentladung bewirkt.

3. Verfahren nach einem der Ansprüche 1 und 2, **dadurch gekennzeichnet, dass** die erste Zündung der Funkenentladung mittels einer Zündvorrichtung, vorzugsweise mittels einer DC-Gleichspannungsquelle bewerkstelligt wird, nach Zünden des Funkens der Kondensator erstmals zugeschalten wird und dieser zum Zeitpunkt des erstmaligen Zuschaltens mittels Mitteln zum Laden auf einen ersten Ladungszustand hat und die Funkenentladung anschliessend bei abgeschalteter DC-Gleichspannungsquelle weiter betrieben wird.

4. Verfahren nach Anspruch 3, **dadurch gekennzeichnet, dass** eine zweite Vielzahl der abgeschalteten Zeitintervalle in Abhängigkeit der Mittel zum Laden des zumindest einen Kondensators so lange gewählt werden, dass der Kondensator nach Ablauf der zweiten Vielzahl der abgeschalteten Zeitintervalle im Wesentlichen den ersten Ladezustand erreicht hat.

5. Verfahren zum Betreiben einer kathodischen Funkenverdampfung, **dadurch gekennzeichnet, dass** die Funkenverdampfung mittels eine Funkenentladung gemäss einem der vorangehenden Ansprüche betrieben wird.

6. Verfahren zum Beschichten von Substraten welches folgende Schritte umfasst:
- Bereitstellen von Substraten
- Einbringen der Substrate in eine Vakuumkammer
- Abpumpen der Vakuumkammer
- Durchführung einer kathodischen Funkenverdampfung nach Anspruch 5

7. Verfahren nach Anspruch 6, **dadurch gekennzeichnet dass** wasserstofffreie und/oder wasserstoffhaltige und/oder metallfreie und/oder metallhaltige Kohlenstoffschichten hergestellt werden.

## Claims

1. Method for operating a pulsed discontinuous spark discharge that is achieved by means of the discharge of at least one capacitor and where the corresponding discharge current is controlled by periodical switching on and off of the capacitor, wherein when the capacitor is switched off during the switched-off time intervals, no current is supplied from the supply, **characterized in that** within the switched-on time intervals the discharge current is momentarily interrupted upon reaching a previously determined threshold, with the result that subpulses occur within the pulses.

2. Method according to claim 1, **characterized in that** at least a first plurality of the switched-off time intervals is chosen so short that after their respective expiration, the switching on of the capacitor readily causes the renewed ignition of the spark discharge.

3. Method according to one of the claims 1 and 2, **characterized in that** the first ignition of the spark discharge is achieved by means of an ignition device, preferably by means of a DC direct voltage source, and after ignition of the spark the capacitor is switched on for the first time and has at the time of the first ignition by means of charging means a first charge state and the spark discharge is subsequently further operated with the DC direct voltage source switched off.

4. Method according to claim 3, **characterized in that** a second plurality of switched-off time intervals can, depending on the charging means of the at least one capacitor, be chosen so long that the capacitor after expiration of the second plurality of switched-off time intervals has essentially reached the first charge state.

5. Method for operating a cathodic spark evaporation, **characterized in that** the spark evaporation is operated by means of a spark discharge according to one of the preceding claims.

6. Method for coating substrates that comprises the following steps:
- providing substrates
- placing the substrates in a vacuum chamber
- pumping out the vacuum chamber
- performing a cathodic spark evaporation according to claim 5.

7. Method according to claim 6, **characterized in that** it is possible to produce carbon layers that are hydrogen-free and/or contain hydrogen and/or metal-free and/or contain metal.

## Revendications

1. Procédé pour exercer une décharge d'étincelles discontinue pulsée qui est réalisée au moyen de décharge de pour le moins un condensateur, et le courant de décharge est réglé par le fait de connecter et déconnecter le condensateur, dans lequel, quand le condensateur est déconnecté, pendant les intervalles de temps déconnectés aucun courant est alimenter à partir de l'alimentation, **caractérisé par le fait que** dans les intervalles de temps connectés le courant de décharge est interrompu temporairement lorsqu'il atteint un ordre de grandeur préalablement fixé, et que cela donne lieu aux sous-pulses au sein du pulse.

2. Procédé selon la revendication 1, **caractérisé par le fait que** pour le moins une première pluralité des intervalles déconnectés est sélectionnée aussi courte qu'après l'écoulement de chacun de ceux-ci la connexion du condensateur cause de nouveau l'allumage de la décharge d'étincelles sans aucun problème.

3. Procédé selon l'une des revendications 1 et 2, **caractérisé par le fait que** le premier allumage de la décharge d'étincelles est réalisé au moyen d'un dispositif allumeur, préférablement au moyen d'une source de tension continue, après l'allumage de l'étincelle le condensateur est connecté pour la premier fois, et celui-ci, au moment de la première connexion au moyen des moyens pour la charge, a un premier état de charge et la décharge d'étincelles est ensuite continue avec la source de tension continue déconnectée.

4. Procédé selon la revendication 3, **caractérisé par le fait qu'**une deuxième pluralité des intervalles déconnectés est sélectionnée aussi longtemps selon les moyens pour la décharge de l'un au moins du condensateur que le condensateur a sensiblement atteint le premier état de décharge après l'écoulement de la deuxième pluralité des intervalles déconnectés.

5. Procédé pour la réalisation d'une vaporisation d'étincelles cathodique, **caractérisé par le fait que** la vaporisation d'étincelles est réalisée au moyen de décharge d'étincelles selon l'une des revendications précédentes.

6. Procédé pour le revêtement de substrats comprenant des étapes suivantes consistant à :
- fournir des substrats
- introduire les substrats dans une chambre à vide
- évacuer la chambre à vide
- mettre en oeuvre une vaporisation d'étincelles cathodique selon la revendication 5.

7. Procédé selon la revendication 6, **caractérisé par le fait que** des couches de carbone sans hydrogène et/ou hydrogénées et/ou sans métal et/ou métallifères sont fabriquées.
